# EUROPÄISCHE PATENTSCHRIFT

(11) **EP 0 679 878 B1**
(45) Veröffentlichungstag und Bekanntmachung des Hinweises auf die Patenterteilung: **25.08.1999**
(21) Anmeldenummer: 95106099.5
(22) Anmeldetag: 24.04.1995
(51) Int. Cl.: G01L 1/14, G01P 15/125, H02N 1/00, H01H 1/00

(54) **Mikrosystem mit integrierter Schaltung und mikromechanischem Bauteil und Herstellverfahren**
Microsystem with integrated circuit and micromechanical component and fabrication procedure
Microsystème avec circuit intégré et composante micromécanique et procédé de fabrication

(30) Priorität: 28.04.1994 DE 4414968
(43) Veröffentlichungstag der Anmeldung: 02.11.1995
(73) Patentinhaber: SIEMENS AKTIENGESELLSCHAFT, 80333 München (DE)
(72) Erfinder: Zettler, Thomas, Dr., D-81737 München (DE)

(56) Entgegenhaltungen:
- WO-A-93/25915
- TRANSDUCERS '91. 1991 INTERNATIONAL CONFERENCE ON SOLID-STATE SENSORS AND ACTUATORS. DIGEST OF TECHNICAL PAPERS (CAT. NO.91CH2817-5), SAN FRANCISCO, CA, USA, 24-27 JUNE 1991, ISBN 0-87942-585-7, 1991, NEW YORK, NY, USA, IEEE, USA, Seiten 51-54, XP000647175 HACKETT R H ET AL: "The integration of micro-machine fabrication with electronic device fabrication on III-V semiconductor materials"

## Beschreibung

Die Erfindung betrifft ein Mikrosystem auf einem Halbleitersubstrat mit einer integrierten Schaltung und einem mikromechanischen Bauteil sowie ein Verfahren zu seiner Herstellung.

Bei der Herstellung von mikromechanischen Bauteilen für den Einsatz beispielsweise als Aktoren und Sensoren besteht ein großes Interesse an Prozessen, die mit der Fertigung von integrierten Schaltungen, insbesondere auf einem Silizium-Substrat, kompatibel sind. Nur eine Kompatibilität der Herstellungsprozesse erlaubt die Integration von Mikromechanik und Ansteuer- oder Auswerteschaltungen in Mikrosystemen. Dies ist auch dann wichtig, wenn bestehende Halbleiterfertigungsanlagen auch zur Herstellung von mikromechanischen Strukturen genutzt werden sollen. Besonders vorteilhaft wäre ein Prozeß, mit dem gleichzeitig eine integrierte Schaltung und ein mikromechanisches Bauteil in verschiedenen Bereichen des Halbleitersubstrats erzeugt werden kann, d.h. ein Mikrosystem ohne - oder mit nur minimalem - zusätzlichen Prozeßaufwand zur integrierten Schaltung hergestellt werden kann.

Für Mikrosysteme kommen vor allem mikromechanische Bauteile in Betracht, deren Funktion auf elektrostatischen Kräften, insbesondere zwischen Kondensatorflächen mit variablem Abstand, beruht, da hierbei grundsätzlich eine geeignete Kombination von leitenden und nichtleitenden Schichten, die auch bei integrierten Schaltungen eingesetzt werden, ausreichend ist. Derartige mikromechanische Bauteile bestehen aus festen und beweglichen mikromechanischen Strukturen. Ein typisches Anwendungsbeispiel ist ein Motor (mit Drehachse und Stator als fester bzw. Rotor als beweglicher mikromechanischer Struktur), ein Getriebe, oder ein proportionaler oder nicht-proportionaler Kraftsensor.

Für mikromechanische Bauteile sind u.a. folgende Herstellprozesse bekannt:
a) Polysilizium-Center-pin- und -Flange-Prozeß (M. Mehrengany, Y.-C. Tai, J. Micromech. Microeng., vol. 1, 73, 1991)
   Dieser Prozeß erfordert bei der Herstellung der mikromechanischen Strukturen im Anschluß an die Herstellung der integrierten Schaltung zusätzliche Polysiliziumabscheidungen nach dem Metallisierungskomplex. Im Fall, daß der Center-Pin-Prozeß vor der Metallisierung der integrierten Schaltung durchgeführt werden soll, ergibt sich das Problem, die beweglichen Strukturen freizuätzen, und gleichzeitig die Isolation der Metallisierung zu schützen. Ein weiterer Nachteil ist der relativ hohe spezifische Widerstand von dotiertem Polysilizium.
b) Polysilizium-LOCOS-Prozeß (L.S. Tavrow et al, Sensors and Actuators A, Phys. vol. A35, 33, 1992):
   Der Prozeß sieht vor, die beweglichen mikromechanischen Strukturen auf einer planen LOCOS-0xidschicht herzustellen, wobei der Oxidationsschritt wegen der Temperaturbelastung nur vor der Transistorherstellung einer integrierten Schaltung erfolgen kann. Bei vollständiger Durchführung des Prozesses vor Herstellung der integrierten Schaltung ergibt sich eine ungünstige Topologie für die Nachfolgeschritte sowie das Problem, die mikromechanischen Strukturen während der Herstellung der integrierten Schaltung zu schützen. Bei einer ineinander verzahnten Herstellung muß das Problem der Freiätzung des Rotors bei gleichzeitigem Schutz der Schaltungsisolationsoxide gelöst werden.
c) Selektiver Wolfram-Prozeß (L.Y.Chen et al, TRANSDUCERS '91., Int. Conf. on Solid-State Sensors and Actuators. San Francisco, USA, IEEE Cat. No. 91CH2817-5, 739, 1991): Dieser Prozeß kann im Anschluß an einen Schaltungs-Fertigungsprozeß durchgeführt werden, wobei das Problem der elektrischen Kontaktierung und des Schutzes der Metallisierungsisolation durch das vorgeschlagene Verfahren nicht gelöst werden. Der Prozeß ist insbesondere bezüglich der Lithographieschritte sehr aufwendig.
d) LIGA-Prozeß (P.Bley et al, Microelectronic Engineering 13, 509, 1991; H. Guckel et al, Conf. Proceedings IEEE-Micro Electro Mechanical Systems, Nara, Japan, 1991): Dieser Prozeß benötigt Röntgenstrahl-Lithographie und eventuell eine nachträgliche Montage von losen mikroskopischen Bauteilen.
   Für Mikrosysteme mit integrierter Schaltung und mikromechanischen Bauteilen sind folgende Dokumente bekannt:
e) Transducers '91. 1991 International conference on solid-state sensors and actuators. Digest of technical papers (Cat. No. 91CH2817-5), San Francisco, CA, USA, 24-27 June 1991, ISBN 0-87942-585-7, 1991, New York, NY USA, IEEE, USA, Seiten 51-54, XP000647175 Hackett R.H. ET Al "The integration of micro-machine fabrication with electronic device fabrication on III-V semiconductor materials". Dieses Dokument beschreibt ein Herstellverfahren von Mikrosystemen auf Halbleitersubstraten (III-V Komponenten) mit integrierter Schaltung und mikromechanischem Bauteil auf demselben Träger.
f) WO-A-93/25915 "Method for fabricating monolithic chip containing integrated circuitry and self-supporting microstructure".
   Dieses Dokument beschreibt ein Herstellverfahren für einen "monolithic chip" mit integrierter Schaltung und einem mikromechanischen Bauteil aus Polysilizium. Das Herstellverfahren beinhaltet 67 Prozesse mit insgesamt 330 Schritten. Das Verfahren ermöglicht die Erstellung der integrierten Schaltung und des mikromechanischen Bauteils auf demselben Träger (Chip).

Alle diese Prozesse sind in ihrer Konzeption nicht für die gemeinsame und insbesondere gleichzeitige Fertigung von integrierter Schaltung und dem mikromechanischen Bauteil in einem Mikrosystem ausgelegt. Sie benötigen eine Vielzahl von Schichten und Prozeßschritten, welche ausschließlich der Herstellung des mikromechanischen Bauteils dienen und die für die Herstellung einer integrierten Schaltung überflüssig oder sogar einschränkend oder nachteilig sind.

Der Erfindung liegt daher die Aufgabe zugrunde, ein Mikrosystem mit einer integrierten Schaltung (IS) und ein mikromechanisches Bauteil anzugeben, bei welchem ausgehend von der IS-Herstellung kein zusätzlicher Prozeßaufwand für die Herstellung des mikromechanischen Bauteils notwendig ist, sowie ein Herstellverfahren anzugeben, mit dem die integrierte Schaltung und das mikromechanische Bauteil eines Mikrosystems gleichzeitig hergestellt werden können.

Diese Aufgabe wird durch die Merkmale der Ansprüche 1 und 10 gelöst.

Die Erfindung beruht auf der Verwendung von bereits für die integrierte Schaltung benötigten Schichten als Teile des mikromechanischen Bauteils. Die Schichten müssen lediglich durch ein entsprechendes Design so strukturiert werden, daß im Bereich des mikromechanischen Bauteils die für die beabsichtigte Funktion benötigten Strukturen gebildet werden. Die integrierte Schaltung kann in jeder gewünschten Technologie (z.B CMOS, Bipolar, BICMOS) ausgeführt werden.

Da das mikromechanische Bauteil im allgemeinen auch eine elektrische Funktion übernehmen soll, werden für seine festen und beweglichen mikromechanischen Strukturen leitende Schichten eingesetzt. Insbesondere bestehen diese Strukturen ganz oder teilweise aus einer Metallisierungsschicht, die im Bereich der integrierten Schaltung für die Verdrahtung verschiedener Schaltungselemente eingesetzt wird. Die integrierte Schaltung kann eine Ein- oder Mehrlagenverdrahtung (d.h. eine oder mehrere Metallisierungsebenen) aufweisen, von denen eine, mehrere oder alle für das mikromechanische Bauteil verwendet werden können.

Die leitende Schicht ist mindestens im Bereich der integrierten Schaltung auf einer isolierenden Schicht aufgebracht, die üblicherweise als Zwischenoxid bezeichnet wird, und über sie mechanisch mit tieferliegenden Strukturen (allgemein als Substrat bezeichnet) verbunden. Der elektrische Kontakt zu tiefer liegenden Schaltungselementen erfolgt über Kontakte in der isolierenden Schicht. Über einen gleichzeitig hergestellten Kontakt kann eine elektrische und/oder mechanische Verbindung zum Substrat im Bereich des mikromechanischen Bauteils realisiert werden; beispielsweise kann die Achse eines Motors oder eine Elektrode als festes mikromechanisches Bauteil mit dem Substrat verbunden werden.

Im Bereich des mikromechanischen Bauteils kann die isolierende Schicht unter einer festen mikromechanischen Struktur als Verbindung bleiben oder entfernt werden. In der Umgebung einer beweglichen Struktur wird die isolierende Schicht vollständig entfernt. Dies geschieht durch einen Ätzprozeß, der eine ausreichende Selektivität zur leitenden Schicht (also zum Material der beweglichen Struktur) aufweist, und der eine isotrope Komponente besitzt, um die bewegliche Struktur vollständig zu unterätzen. Der Ätzprozeß wird unter Einsatz einer Maske durchgeführt, die über der beweglichen mikromechanischen Struktur eine ausreichend große Öffnung besitzt, um - in Abhängigkeit von der Isotropie des Ätzprozesses und dem zu unterätzenden Bereich - die notwendige Freilegung der beweglichen Struktur zu gewährleisten. Im Bereich der integrierten Schaltung werden mit dem Ätzprozeß die Anschlußpads der Schaltung freigelegt.

Bei einer frei beweglichen mikromechanischen Struktur besitzt diese nach dem Ätzprozeß keine Verbindung mehr zum übrigen Bauteil. Bei einer federnd beweglichen mikromechanischen Struktur ist noch eine Verbindung vorhanden, und zwar vorzugsweise über einen seitlich herausgeführten Teil der leitenden Schicht mit geringer Querschnittsfläche, der auf seiner anderen Seite z.B. mit einer Befestigungsplatte verbunden ist und als Federelement zwischen beweglicher Struktur und Befestigungsplatte wirkt.

Das mikromechanische Bauteil entsteht also ohne zusätzlichen Aufwand zum Herstellungsprozeß für die integrierte Schaltung: Sowohl die leitenden und isolierenden Schichten als auch die Ätzprozesse sind bereits für die integrierte Schaltung notwendig, lediglich die Masken müssen im Bereich des mikromechanischen Bauteils entsprechend angepaßt werden.

Die Erfindung wird im folgenden anhand von Ausführungsbeispielen, die in den Figuren dargestellt sind, näher erläutert. Es zeigen:
- FIG 1 bis 2: einen Querschnitt durch ein Halbleitersubstrat mit einem Ausschnitt aus einer integrierten Schaltung (Bereich IS) und einem mikromechanischen Bauteil (Bereich BT), an dem das Verfahren verdeutlicht wird,
- FIG 3 bis 4: eine Aufsicht auf das mikromechanische Bauteil aus FIG 1 und 2 nach Strukturierung der ersten bzw. zweiten Metallisierungsebene,
- FIG 5 bis 7: einen Querschnitt durch bzw. eine Aufsicht auf ein mikromechanisches Bauteil gemäß einer weiteren Ausführungsform der Erfindung.

### FIG 1 bis 4:

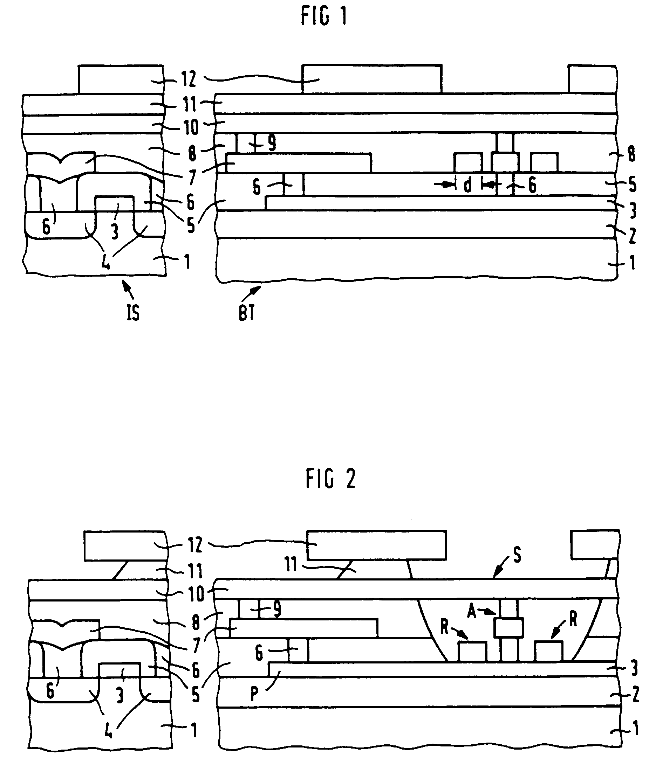

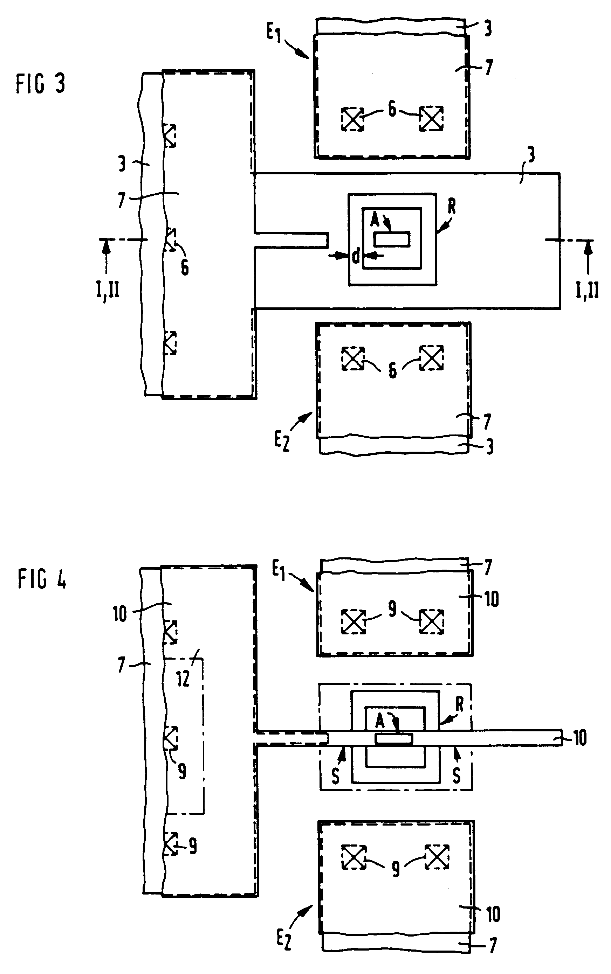

Als erstes Ausführungsbeispiel wird ein mikromechanisches Bauteil beschrieben, das als Mikromotor eingesetzt werden kann. Es besitzt (s. FIG 2, 4) eine Achse A und Elektroden E als feste mikromechanische Bauteile sowie einen Ring R als bewegliches mikromechanisches Bauteil. In FIG 1 und 2 liegen die Elektroden E vor bzw. hinter der Zeichenebene.

In FIG 1 ist ein Silizium-Halbleitersubstrat 1 mit einem Feldoxid 2 dargestellt. Weitere, für die Herstellung einer integrierten Schaltung (IS) notwendigen Verfahrensschritte werden ebenfalls vorgenommen, bei einer CMOS-Schaltung also beispielsweise Herstellen von epitaktischen Schichten, dotierten Wannen, Kanalimplantation, Gate-0xid. Für die Gate-Ebene der IS wird eine Polysiliziumschicht 3 abgeschieden und strukturiert. Im Bereich des mikromechanischen Bauteils (BT-Bereich) wird diese wie in FIG 3 dargestellt strukturiert, d.h. sie verbleibt unterhalb der späteren beweglichen Struktur und dient dort u.a. als Ätzstop sowie über den Teil P als elektrischer Anschluß. Vor und hinter der Zeichenebene von FIG 1 und 2 werden getrennte Polysilizium-Flächen gebildet, die später mit den Elektroden E₁, E₂ des Motors verbunden werden.
Im IS-Bereich wird ein Gate 3 gebildet, und es wird u.a. eine Implantation der Source/Drain-Gebiete 4 durchgeführt.

Auf der Polysiliziumebene 3 befindet sich ein vorzugsweise planares Zwischenoxid 5 als isolierende Schicht, in der an vorgegebenen Stellen Kontakte 6 zur Polysiliziumebene oder zu tiefer liegenden Ebenen vorhanden sind. Im BT-Bereich bildet ein solcher Kontakt einen Teil der Achse A, ein oder mehrere der Kontakte können auf den Polysilizium-Elektroden angeordnet sein. Über einen solchen Kontakt 6 wird auch der in FIG 1 und 2 dargestellte Teil P der Polysiliziumschicht 3 nach oben angeschlossen.
Im IS-Bereich können die Gate-Ebene oder die S/D-Gebiete 4 angeschlossen werden.

Auf dem Zwischenoxid 5 befindet sich als leitende Schicht eine erste Metallebene 7, beispielsweise aus AlSi, die geeignet strukturiert ist. Im BT-Bereich werden Metallelektroden E₁, E₂ (Fig. 3, 4) strukturiert, die vorzugsweise in etwa deckungsgleich mit den Polysilizium-Elektroden sind und mit diesen über die Kontakte 6 verbunden sind. Als weitere feste mikromechanische Struktur wird ein Teil der Achse A aus der ersten Metallisierungsebene gebildet. Ebenfalls wird eine (später) bewegliche mikromechanische Struktur gebildet, beispielsweise in Form einer in sich geschlossenen Bahn (Ring R) um die Achse herum und ohne Verbindung zu ihr. Da der Ring später durch Unterätzung völlig freigelegt werden soll, besitzt er eine relativ geringe Bahnbreite d.
Im IS-Bereich kann die erste Metallisierungsebene 7 beispielsweise zum Anschluß von S/D-Gebieten von Transistoren dienen oder auch gleichzeitig als leitfähige Füllung der Kontakte 6.

Die erste Metallisierungsebene 7 ist mit einem vorzugsweise planaren Intermetalldielektrikum 8, beispielsweise einem geeigneten 0xid, abgedeckt. In diesem sind an vorgegebenen Stellen Kontakte, sogenannte Vias 9, angeordnet. Im BT-Bereich bilden ein oder mehrere Vias 9 wiederum einen Teil der Achse A sowie evtl. der Elektroden E₁, E₂.
Im IS-Bereich ist die erste Metallisierungsebene über die Vias 9 angeschlossen.

Auf dem Intermetalldielektrikum 8 befindet sich eine zweite Metallisierungsebene 10, beispielsweise aus AlSi. Sie wird so strukturiert, daß sie im BT-Bereich eine Sicherung S gegen das Herausfallen der später freizulegenden beweglichen Strukturen darstellt, beispielsweise indem ein geschlossener Bügel mit Hilfe der unterliegenden Schichten gebildet wird, oder indem auf der Achse eine Fläche gebildet wird, die einen größeren Durchmesser als den entsprechenden Innendurchmesser des Rings 7 besitzt. Außerdem ist über die zweite Metallisierungsebene 10, Via 9, erste Metallisierungsebene 7, Kontakt 6 und den seitlichen Teil P die Polysiliziumschicht 3, wie in FIG 2 dargestellt, nach außen anschließbar. In den Figuren ist zusätzlich ein direkter Anschluß der Achse A über die 2. Metallisierung 10 dargestellt.
Im IS-Bereich werden mit der ersten und/oder zweiten Metallisierungsebene 7, 10 verschiedene Schaltungselemente verdrahtet. Insbesonderer werden auch Verbindungsleitungen zwischen dem mikromechanischen Bauteil und einer im IS-Bereich hergestellten Auswerte- oder Ansteuerschaltung aus der oder den Metallisierungsebenen gebildet.

Die gesamte Anordnung wird mit einer Passivierung 11, beispielsweise aus Plasmaoxid und Plasmanitrid, abgedeckt. Es wird eine Maske aufgebracht, die im BT-Bereich eine Öffnung oberhalb der freizulegenden beweglichen Struktur und oberhalb des Anschlußpads für die Polysiliziumschicht 3 und im IS-Bereich oberhalb der von außen anzuschließenden Pads aufweist, dann werden die isolierenden Schichten 5, 8, 11 geätzt. Dabei müssen folgende Bedingungen berücksichtigt werden:
- Der Ätzprozeß muß ausreichend selektiv zu den leitenden Schichten 6, 7, 9, 10 und in diesem Beispiel auch zum Polysilizium 3 sein,
- die isotrope Komponente des Ätzprozesses und die Größe der Öffnung in der Maske müssen unter Berücksichtigung der einzelnen Schichtdicken so gewählt sein, daß der Ring mit Breite d (und hier auch die Sicherung S) völlig unterätzt wird. In diesem Beispiel sollten die Kanten der Elektroden (s.FIG 3, 4) durch den Ätzprozeß ebenfalls freigelegt werden. Im IS-Bereich muß die Ätzung auf dem Metall-2-Pad stoppen. In FIG 4 sind die Kanten der Lackmaske 12 gestrichelt dargestellt.

Der Ätzprozeß wird vorzugsweise als Naßätzung mit einer gepufferten HF-Lösung oder als mikrowellenunterstützte Trockenätzung durchgeführt.

Für die einzelnen Schritte des Herstellungsverfahrens können die aus der IS-Fertigung bekannten Prozesse eingesetzt werden. Beispielsweise kann die Herstellung der Metallebenen auch gleichzeitig mit der Auffüllung der Kontakte bzw. Vias erfolgen, indem nach Ätzen der Kontaktlöcher (bzw. Vialöcher) in die entsprechende Isolationsschicht eine Haftschicht (beispielsweise 40nm Ti + 100nm TiN) abgeschieden und dann in einem CVD-Prozeß Wolfram zur Kontaktlochauffüllung und gleichzeitig als Metallisierungsebenen aufgebracht wird.

Das Bauteil kann als Mikroaktuator bzw. linearer Mikromotor verwendet werden. Dazu werden der in Figur 1 dargestellte Ring R und die Achse A über die Polysiliziumschicht 3 auf Masse gelegt, indem der seitlich herausgeführte Teil P der Polysiliziumschicht 3 und die darüber liegenden leitenden Schichten über das Anschlußpad 10 mit einem Massepotential verbunden werden bzw. A wird direkt über das Pad 10 auf Masse gelegt. Die in FIG 3 und 4 dargestellten Elektroden El, E2 werden wechselweise auf Masse und eine positive Spannung gelegt. Durch das im gleichen Takt wechselnde elektrostatische Feld wird der Ring R wechselweise zu der jeweiligen Elektrode bewegt. Zur Überwindung der Gleitreibung sind bei einem Spalt von 3µm zwischen Ring und Elektrode Spannungen von etwa 50V bis 100V notwendig. Um solche Spannungen ausreichend zu isolieren, wird die gesamte Struktur vorzugsweise auf Feldoxid aufgebaut, wie in FIG 1 und 2 dargestellt. Da die Elektroden aus den übereinanderliegenden und miteinander verbundenen leitenden Schichten 3, 7, 10 bestehen, wird ein sehr homogenes Feld erzeugt. Ein derartiger Linear-Motor wurde mit folgenden Design-Maßen (Aufsicht) hergestellt:
Achse 8µm x 1,6µm
Ring innen Ø 9,8µm x 3,4µm außen Ø 11,8µm x 5,4µm
Abstand Ringaußenkante - Elektrodenkanten 2µm
und konnte bei 90V betrieben werden.

Ferner kann das Bauteil als Gravitations- bzw. Beschleunigungssensor verwendet werden. In Abhängigkeit von einer erfolgten Beschleunigung oder der räumlichen Orientierung des Substrats hat der Ring R einen großen oder kleinen Abstand zu den Elektroden in FIG 3, 4. Diese Abstandsänderung kann kapazitiv detektiert werden. Es ist vorteilhaft, aber nicht notwendig, in dem isotropen Ätzprozeß die Kanten der Elektroden E freizuätzen. Die notwendige Meßschaltung kann auf demselben Substrat ohne Zusatzaufwand gefertigt werden.

Das Bauteil kann auch als Schalter verwendet werden, wenn die Elektroden E1, E2 an den Kanten freigeätzt werden und der Ring R so dimensioniert ist, daß er die Elektroden E berühren kann. Je nach Lage des Ringes wird ein elektrischer Kontakt zwischen einer oder mehreren Elektrodenschichten und der unter dem Ring liegenden Polysiliziumschicht 3 geschlossen.

Das Bauteil kann als nichtproportionaler Kraftsensor (Ereignissensor) universell eingesetzt werden. So kann die (kapazitiv oder als Kurzschluß) zu detektierende Lageveränderung des Ringes auch z.B. durch die Kraft von strömenden Medien oder direkte mechanische Einwirkung hervorgerufen werden.

### FIG 5 bis 7:

Als zweites Beispiel wird ein mikromechanisches Bauteil beschrieben, das als proportionaler Kraftsensor eingesetzt werden kann. Es umfaßt
- ein Masse-Element M, das aus einer leitenden Schicht der IS-Verdrahtung gebildet und federnd aufgehängt ist,
- ein Feder-Element F, welches auf einer Seite mit dem Masse-Element und auf der anderen Seite mit einer Befestigungsplatte verbunden ist,
- eine Befestigungsplatte B, die mit dem Substrat und dem Feder-Element verbunden ist, und
- eine Elektrode E, die mit dem Masse-Element einen Kondensator bildet.

Vorzugsweise sind diese Strukturen alle aus derselben leitenden Schicht gebildet. Es kann jedoch bei bestimmten Aufgabenstellungen auch vorteilhaft sein, beispielsweise Masse-Element und Elektrode aus verschiedenen leitenden Schichten herzustellen. Die Befestigungsplatte und die Elektrode stellen feste mikromechansiche Bauteile dar, das Masse-Element und das Feder-Element (zumindest über einen ausreichenden Teil) bewegliche mikromechanische Strukturen. Die Befestigungsplatte übernimmt vorzugsweise sowohl die Aufgabe einer mechanischen Verbindung des Feder-Elementes mit dem Substrat als auch die einer elektrischen Verbindung zu einer Auswerteschaltung vermittels einer Leitung L. Die Elektrode E ist ebenfalls über eine Leitung L mit der Auswerteschaltung verbunden.

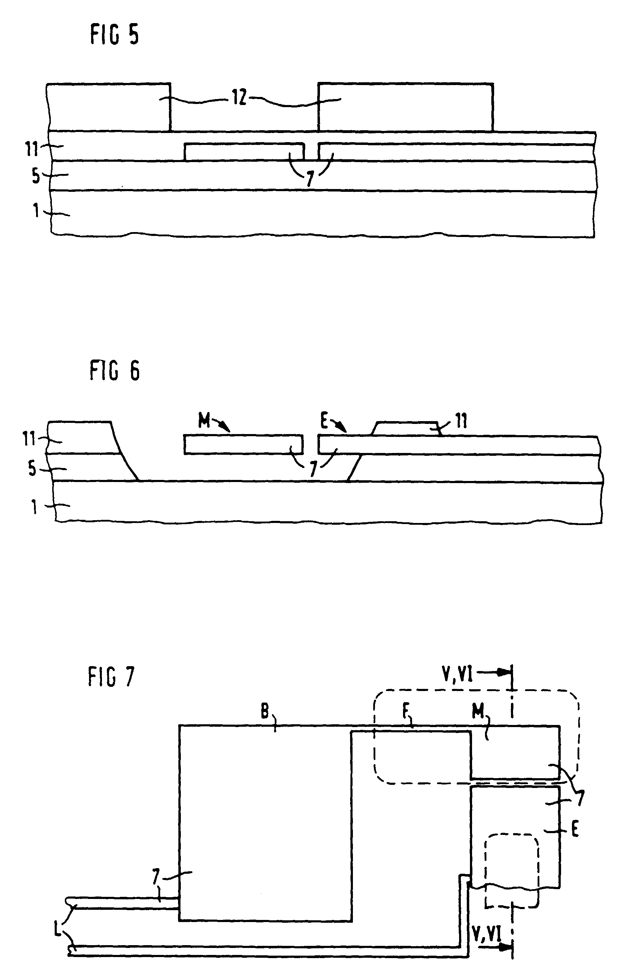

Das Bauteil kann mit dem beim ersten Beispiel beschriebenen Verfahren hergestellt werden. Es kann auch bei einem Mikrosystem mit einer Einlagenmetallisierung eingesetzt werden, dann weist es im BT-Bereich die in den FIG 5 und 6 angegebene Schichtenfolge auf (Bezugsziffern wie in den FIG 1 und 2, IS-Bereich nicht dargestellt). Das Substrat 1, an dem im allgemeinen schon eine Vielzahl an Prozeßschritten für die integrierte Schaltung vorgenommen wurde, kann an seiner Oberfläche eine beliebige Schicht aufweisen, beispielsweise Feldoxid oder Polysilizium. Darauf befindet sich das Zwischenoxid 5 als isolierende Schicht und die Metallisierungsebene 7 als leitende Schicht. Die Metallisierungsebene wird wie in FIG 7 dargestellt zu dem Masse-Element M, dem Feder-Element F, der Befestigungsplatte B, der Elektrode E und den Leitungen L zur Auswerteelektronik strukturiert. Die Befestigungsplatte B kann auch entfallen, und das Feder-Element kann direkt in die Leitungen übergehen. Die Metallisierungsebene 7 ist mit der Passivierung 11 abgedeckt.

Die Photomaske 12 für den isotropen Ätzprozeß besitzt eine ausreichend große Öffnung, so daß wie bereits erläutert, mindestens das Masse-Element M und ein für die Federwirkung ausreichender Teil des Feder-Elementes F unterätzt werden (FIG 6). Ferner sollte zumindest die Kante der Elektrode E freigelegt werden. Die Befestigungsplatte B wird nicht frei- oder unterätzt, um eine sichere mechanische Befestigung über die isolierende Schicht 5 mit dem Substrat 1 zu gewährleisten. Die Photomaske 12 kann wie dargestellt eine weitere Öffnung über der Elektrode E besitzen, die so dimensioniert ist, daß der Ätzprozeß auf der Elektrode stoppt. Dann kann die Elektrode auch von oben direkt kontaktiert werden. Im (nicht dargestellten) IS-Bereich besitzt die Photomaske Öffnungen über den Metallisierungs-Pads, die von außen angeschlossen werden sollen. Nach Entfernung der Maske 12 wird das Mikrosystem gemäß dem üblichen IS-Prozeß fertiggestellt.

Bei einer Mehrlagenverdrahtung können die beweglichen und festen Strukturen beispielsweise alle aus der obersten Verdrahtungsebene gebildet werden. Sie können auch aus verschiedenen Ebenen gebildet werden, bzw. können die Leitungen L aus einer höheren Verdrahtungsebene als die übrigen Strukturen hergestellt werden.

Wirkt auf das Masse-Element M eine Kraft, so verbiegt sich die Feder F, und das Masse-Element verändert seinen Ort. Die Ortsveränderung kann als Kapazitätsänderung zwischen dem Masse-Element und der Elektrode nachgewiesen werden. Durch die Rückstellkraft der Feder verändert sich das Kapazitätssignal monoton mit der einwirkenden Kraft. Das Bauelement kann daher als Beschleunigungssensor benutzt werden, indem man die Trägheitskraft auf das Masse-Element ausnutzt. Es ist jedoch genauso möglich, andere Krafteinwirkungen auf das Masse-Element zu detektieren. So können z.B. die Kraft einer strömenden Flüssigkeit oder eines Gases oder die direkte Krafteinwirkung eines externen mechanischen Bauteils nachgewiesen werden. Masse und Elektrode können auch übereinanderliegend angeordnet werden, wobei die Verbiegung der Feder in der entsprecheden Richtung erfolgt.

Das Bauteil kann auch als Schalter verwendet werden, wenn die Kante der Elektrode E freigelegt ist. Die Krafteinwirkung auf das Masse-Element wird dadurch nachgewiesen, daß ein Kurzschluß zwischen der Elektrode (bzw. mehreren Elektroden und dem Masse-Element hergestellt wird. Der Kurzschluß entsteht, wenn die einwirkende Kraft größer gleich der Federrückstellkraft bei Maximalverbiegung (Anschlag) ist.

Das in FIG 5 und 7 dargestellte Bauteil kann weiterhin als Aktuator verwendet werden. Dazu werden an Masse-Element M, Federelement F, Befestigungsplatte B einerseits, und an die Elektrode andererseits, Spannungen angelegt. Das durch eine Spannungsdifferenz zwischen Masse-Element und Elektrode hervorgerufene elektrostatische Feld übt eine Kraft auf das Masse-Element aus, und bewirkt so eine Verbiegung des Federelements und Verschiebung des Masse-Elementes.

Neben einer quasi statischen Betriebsart ist auch eine dynamische Betriebsart möglich, bei der die angelegte Spannung eine Wechselspannung ist und das Masse-Element zu mechanischen Schwingungen angeregt wird (Oszillator-Funktion). Da die mechanischen Schwingungsamplituden bei Anregung mit der Eigenfrequenz des Feder-Masse-Systems maximal werden und zu einem Extremwert im Wechselstromwiderstand führen, kann das Bauteil als frequenzbestimmendes Element in einer elektronischen Schaltung verwendet werden (Resonator-Funktion).

Die in FIG 5 bis 7 dargestellten Umrisse des Bauteils stellen nur ein Ausführungsbeispiel dar. Andere Formen sind genauso möglich. So können z.B. die gegenüberliegenden Kanten von Elektrode und Masse-Element zur Vergrößerung der Fläche kammartig ausgebildet werden.

## Patentansprüche

1. Mikrosystem auf einem Halbleitersubstrat (1) mit
- einer integrierten Schaltung (IS), welche eine isolierende Schicht (5) und eine darüber angeordnete leitende Schicht (7) umfaßt, die über einen Kontakt (6) in der isolierenden Schicht (5) mit einem tieferliegenden Schaltungselement verbunden ist, und
- einem mikromechanischen Bauteil (BT), welches eine feste mikromechanische Struktur (A, E) und eine bewegliche mikromechanische Struktur (R, F, M) umfaßt, die mindestens teilweise aus der leitenden Schicht (7) bestehen,
wobei
- die feste mikromechanische Struktur mittels der isolierenden Schicht (5) und/oder einem weiteren Kontakt (6) mit dem Substrat (1) verbunden ist,und
- unter der beweglichen mikromechanischen Struktur die isolierende Schicht (5) fehlt.

2. Mikrosystem nach Anspruch 1, bei dem die bewegliche mikromechanische Struktur frei beweglich ist.

3. Mikrosystem nach Anspruch 1, bei dem die bewegliche mikromechanische Struktur federnd beweglich ist.

4. Mikrosystem nach einem der Ansprüche 1 bis 3, bei dem die integrierte Schaltung (IS) mehrere leitende Schichten (7, 10) in Form einer Mehrlagenmetallisierung aufweist und die mikromechanischen Strukturen aus mehreren der Metallisierungsebenen gebildet sind.

5. Mikrosystem nach einem der Ansprüche 1 bis 3, bei dem die integrierte Schaltung (IS) eine Ein- oder Mehrlagenmetallisierung mit der leitenden Schicht 7 aufweist und alle mikromechanischen Strukturen aus derselben leitenden Schicht (7) gebildet sind.

6. Mikrosystem nach einem der Ansprüche 1 bis 2, 4 bis 5, bei dem Sicherungsmittel (S) gegen Herausfallen der frei beweglichen mikromechanischen Struktur (R) vorgesehen sind, die aus einer anderen Metallisierungsebene als die bewegliche Struktur gebildet sind.

7. Mikrosystem nach einem der Ansprüche 1 bis 6, bei dem die leitende Schicht (7) oder die leitenden Schichten (7, 10) aus einer Aluminiumlegierung oder im wesentlichen aus Wolfram bestehen und die isolierende Schicht (5) aus einem Siliziumoxid besteht.

8. Mikrosystem nach einem der Ansprüche 1 bis 7, bei dem das mikromechanische Bauteil (BT) einen proportionalen oder nicht-proportionalen Kraftsensor, einen Oszillator oder einen Resonator darstellt.

9. Mikrosystem nach einem der Ansprüche 1 bis 7, bei dem das mikromechanische Bauteil (BT) einen Mikromotor oder -Aktuator darstellt.

10. Herstellverfahren für ein Mikrosystem mit
- einer integrierten Schaltung (IS) mit einer leitenden Schicht (7) auf einer isolierenden Schicht (5) und
- einem mikromechanischen Bauteil (BT) mit einer festen mikromechanischen Struktur (A, E, B) und einer beweglichen mikromechanischen Struktur,
bei dem
- die feste und die bewegliche mikromechanische Struktur durch eine Strukturierung der leitenden Schicht (7) erzeugt werden, die gleichzeitig mit der Strukturierung der leitenden Schicht (7) im Bereich der integrierten Schaltung erfolgt,
- die bewegliche mikromechanische Struktur durch Entfernung der unter ihr befindlichen isolierenden Schicht (5) in einem Ätzprozeß freigelegt wird, der eine ausreichende Selektivität zur leitenden Schicht (7) aufweist und eine isotrope Komponente besitzt.

11. Herstellverfahren nach Anspruch 10, bei dem als Ätzprozeß eine mikrowellenunterstützte isotrope Trockenätzung durchgeführt wird.

12. Herstellverfahren nach Anspruch 10, bie dem im Ätzprozeß eine gepufferte HF-Lösung verwendet wird.

13. Herstellverfahren nach einem der Ansprüche 10 bis 12, bei dem die integrierte Schaltung (IS) und das mikromechanische Bauteil (BT) mit mehreren leitenden Schichten (7, 10) hergestellt werden, die mit weiteren isolierenden Schichten (8, 11) abgedeckt werden, und bei dem der Ätzprozeß die isolierenden Schichten mit ausreichender Selektivität zu den leitenden Schichten ätzt.

14. Mikrosystem nach einem der Ansprüche 1 bis 9, bei dem die integrierten Schaltung (IS) eine Ansteuer- oder Auswerteschalteschaltung für das mikromechanische Bauteil (BT) umfaßt, die über eine Leitung (L), die aus der leitenden Schicht (7) oder der leitenden Schichten (7, 10) hergestellt ist, mit dem Bauteil (BT) vorhanden ist.

## Claims

1. Microsystem on a semiconductor substrate (1) with
- an integrated circuit (IS) comprising an insulating layer (5) and a conductive layer (7), which is arranged over the said insulating layer and is connected via a contact (6) in the insulating layer (5) to a circuit element lying at a deeper level, and
- a micromechanical component (BT) comprising a fixed micromechanical structure (A, E) and a movable micromechanical structure (R, F, M), which are at least partly composed of the conductive layer (7),
in which
- the fixed micromechanical structure is connected to the substrate (1) by means of the insulating layer (5) and/or a further contact (6), and
- the insulating layer (5) is absent under the movable micromechanical structure.

2. Microsystem according to Claim 1, in which the movable micromechanical structure is freely movable.

3. Microsystem according to Claim 1, in which the movable micromechanical structure is resiliently movable.

4. Microsystem according to one of Claims 1 to 3, in which the integrated circuit (IS) has a plurality of conductive layers (7, 10) in multilayer metallization form, and the micromechanical structures are formed from a plurality of the metallization planes.

5. Microsystem according to one of Claims 1 to 3, in which the integrated circuit (IS) has single- or multilayer metallization with the conductive layer 7, and all the micromechanical structures are formed from the same conductive layer (7).

6. Microsystem according to one of Claims 1 to 2, 4 to 5, in which safeguarding means (S) to prevent the freely movable micromechanical structure (R) from falling out are provided, which means are formed from a different metallization plane from the movable structure.

7. Microsystem according to one of Claims 1 to 6, in which the conductive layer (7) or the conductive layers (7, 10) are composed of an aluminium alloy or essentially of tungsten and the insulating layer (5) is composed of a silicon oxide.

8. Microsystem according to one of Claims 1 to 7, in which the micromechanical component (BT) constitutes a proportional or non-proportional force sensor, an oscillator or a resonator.

9. Microsystem according to one of Claims 1 to 7, in which the micromechanical component (BT) constitutes a micromotor or -actuator.

10. Method for fabricating a microsystem with
- an integrated circuit (IS) with a conductive layer (7) on an insulating layer (5), and
- a micromechanical component (BT) with a fixed micromechanical structure (A, E, B) and a movable micromechanical structure,
in which
- the fixed and the movable micromechanical structures are produced by patterning of the conductive layer (7), which is effected at the same time as the patterning of the conductive layer (7) in the region of the integrated circuit,
- the movable micromechanical structure is uncovered by the insulating layer (5) situated underneath it being removed in an etching process having sufficient selectivity with respect to the conductive layer (7) and having an isotropic component.

11. Fabrication method according to Claim 10, in which the etching process carried out is microwave-assisted isotropic dry etching.

12. Fabrication method according to Claim 10, in which a buffered HF solution is used in the etching process.

13. Fabrication method according to one of Claims 10 to 12, in which the integrated circuit (IS) and the micromechanical component (BT) are fabricated with a plurality of conductive layers (7, 10) which are covered with further insulating layers (8, 11), and in which the etching process etches the insulating layers with sufficient selectivity with respect to the conductive layers.

14. Microsystem according to one of Claims 1 to 9, in which the integrated circuit (IS) comprises a drive or evaluation circuit for the micromechanical component (BT), the latter circuit being connected to the component (BT) via a line (L) fabricated from the conductive layer (7) or the conductive layers (7, 10).

## Revendications

1. Microsystème sur un substrat semi-conducteur (1) comprenant
- un circuit intégré (IS) qui comprend une couche isolante (5) et une couche conductrice (7) disposée au-dessus et qui est connectée à un élément de circuit placé plus profond, au moyen d'un contact (6) formé dans la couche isolante (5), et
- un composant micromécanique (BT) qui comprend une structure micromécanique fixe (A, E) et une structure micromécanique mobile (R, F, M), qui sont au moins partiellement formées à partir de la couche conductrice (7),
dans lequel la structure micromécanique fixe est reliée au substrat (1) au moyen de la couche isolante (5) et/ou d'un autre contact (6), et
- la couche isolante (5) est absente au-dessous de la structure mécanique mobile.

2. Microsystème selon la revendication 1, dans lequel la structure micromécanique mobile est librement mobile.

3. Microsystème selon la revendication 1, dans lequel la structure micromécanique mobile est mobile élastiquement.

4. Microsystème selon une des revendications 1 à 3, dans lequel le circuit intégré (IS) présente plusieurs couches conductrices (7, 10) sous la forme d'une métallisation multicouche, et les structures micromécaniques sont formées à partir de plusieurs des plans de métallisation.

5. Microsystème selon une des revendications 1 à 3, dans lequel le circuit intégré (IS) présente une métallisation monocouche ou multicouche avec la couche conductrice (7) et toutes les structures micromécanique sont formées à partir de la même couche conductrice (7).

6. Microsystème selon une des revendications 1 à 2, 4 à 5, dans lequel il est prévu des moyens de protection (S) protégeant contre la chute de la structure micromécanique mobile (R), qui sont formés à partir d'un plan de métallisation autre que celui de la structure mobile.

7. Microsystème selon une des revendications 1 à 6, dans lequel la couche conductrice (7) ou les couches conductrices (7, 10) sont composées d'un alliage d'aluminium ou essentiellement de tungstène et la couche isolante (5) est composée d'un oxyde de silicium.

8. Microsystème selon une des revendications 1 à 7, dans lequel le composant micromécanique (BT) représente un capteur de force proportionnel ou non proportionnel, un oscillateur ou un résonateur.

9. Microsystème selon une des revendications 1 à 7, dans lequel le composant micromécanique (BT) représente un micromoteur ou un actionneur.

10. Procédé de fabrication pour un microsystème comprenant
- un circuit intégré (IS) possédant une couche conductrice (7) sur une couche isolante (5) et
- un composant micromécanique (BT) possédant une structure micromécanique fixe (A, E, B) et une structure micromécanique mobile
dans lequel
- la structure micromécanique fixe et la structure micromécanique mobile sont produites par une structuration de la couche conductrice (7) qui s'effectue simultanément avec la structuration de la couche conductrice (7) dans la région du circuit intégré,
- la structure micromécanique mobile est dégagée par l'enlèvement de la couche isolante (5) située au-dessous d'elle dans un processus de gravure qui présente une sélectivité suffisante par rapport à la couche conductrice (7) et possède une composante isotrope.

11. Procédé de fabrication selon la revendication 10, dans lequel on exécute, comme processus de gravure, une gravure à sec isotrope assistée par micro-ondes.

12. Procédé de fabrication selon la revendication 10, dans lequel on utilise dans le processus de gravure une solution de HF tamponnée.

13. Procédé de fabrication selon une des revendications 10 à 12, dans lequel le circuit intégré (IS) et le composant micromécanique (BT) sont fabriqués avec plusieurs couches conductrices (7,10), lesquelles sont couvertes d'autres couches isolantes (8, 11) et dans lequel le processus de gravure grave les couches isolantes avec une sélectivité suffisante vis-à-vis des couches conductrices.

14. Microsystème selon une des revendications 1 à 9, dans lequel le circuit intégré (IS) comprend un circuit de pilotage ou un circuit d'analyse pour le composant micromécanique (BT), qui est relié au composant (BT) par un conducteur (L) qui est fabriqué à partir de la couche conductrice (7) ou à partir des couches conductrices (7, 10).
